# EUROPEAN PATENT APPLICATION

(11) **EP 4 776 361 A1**
(43) Date of publication of application: **15.07.2026**
(21) Application number: 25864518.3
(22) Date of filing: 04.11.2025
(51) Int. Cl.: H01M 10/04, H01M 10/0525, H01M 10/058, H01M 10/48, H01R 11/24, H01R 13/24, H01R 13/533, H02J 7/00

(54) **VOLTAGE MEASURING UNIT, BATTERY CELL PRESSING JIG INCLUDING SAME, AND CHARGING AND DISCHARGING DEVICE INCLUDING BATTERY CELL PRESSING JIG**

(30) Priority: 08.11.2024 KR 20240158360; 21.10.2025 KR 20250152456
(71) Applicant: LG Energy Solution, Ltd., Seoul 07335 (KR)
(72) Inventor: LEE, Dong Hee, Daejeon 34122 (KR); JO, Seung Ill, Daejeon 34122 (KR)
(74) Representative: Goddar, Heinz J.
(86) International application number: PCT/KR2025/017873
(87) International publication number: WO 2026/101161

(57) **Abstract**

Disclosed are a voltage measurement unit including a distance adjustment portion constituted by two support shafts coupled so as to cross in an X-shape, bearings coupled to ends of the two support shafts, springs configured to restore by elastic force even if the crossing angle between the support shafts of the distance adjustment portion increases, and an electrode lead guide electrically connected to an electrode lead, a battery cell pressing jig including the same, and a charging and discharging apparatus including the battery cell pressing jig.

## Description

### [Technical Field]

This application claims the benefit of priority to Korean Patent Application No. 2024-0158360 filed on November 8, 2024 and Korean Patent Application No. 2025-0152456 filed on October 21, 2025, the disclosure of which is incorporated herein by reference in its entirety.

The present invention relates to a voltage measurement unit, a battery cell pressing jig including the same, and a charging and discharging apparatus including the battery cell pressing jig. More particularly, the present invention relates to a voltage measurement unit capable of being stably connected to an electrode lead of a battery cell, a battery cell pressing jig capable of being stably connected to an electrode lead of a battery cell when mounting the battery cell on a charging and discharging apparatus and measuring the voltage of the battery cell, and a charging and discharging apparatus including the battery cell pressing jig.

### [Background Art]

With technological development of mobile devices, vehicles, and energy storage systems and an increase in the demand therefor, the demand for batteries as energy sources has sharply increased. Among such secondary batteries is a lithium secondary battery having a high energy density and a high discharge voltage, into which much research has been carried out and which has also been commercialized and widely used.

In particular, the lithium secondary battery operates at a voltage of 3.6 V or higher, which is three times higher than a nickel-cadmium battery or a nickel-metal hydride battery commonly used as a power source for portable electronic devices. In addition, the lithium secondary battery is rapidly gaining prominence due to high energy density per unit weight.

Based on the type of a case, lithium secondary batteries may be classified into a prismatic battery cell using a metal can as a case, a cylindrical battery cell using a metal can as a case, and a pouch-shaped battery cell using a pouch-shaped battery case made of a laminate sheet.

Among the battery cells, the pouch-shaped battery cell is increasingly being applied as an energy source for various devices due to low manufacturing cost, small weight, and easy deformation.

In order to determine whether the pouch-shaped battery cell is defective in the latter part of an assembly process, the voltage of the pouch-shaped battery cell is measured while the pouch-shaped battery cell is charged and discharged in the state in which the pouch-shaped battery cell is pressed.

In order to measure the voltage of the pouch-shaped battery cell, the pouch-shaped battery cell is mounted on a pressing jig, and a voltage measurement unit is connected to an electrode lead. However, if the voltage measurement unit is attached and fixed to a plate of the pressing jig, the connection position between the voltage measurement unit and the electrode lead may change, potentially causing poor contact.

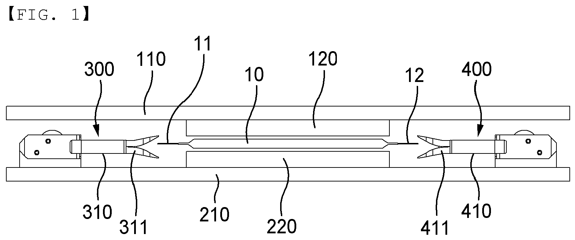

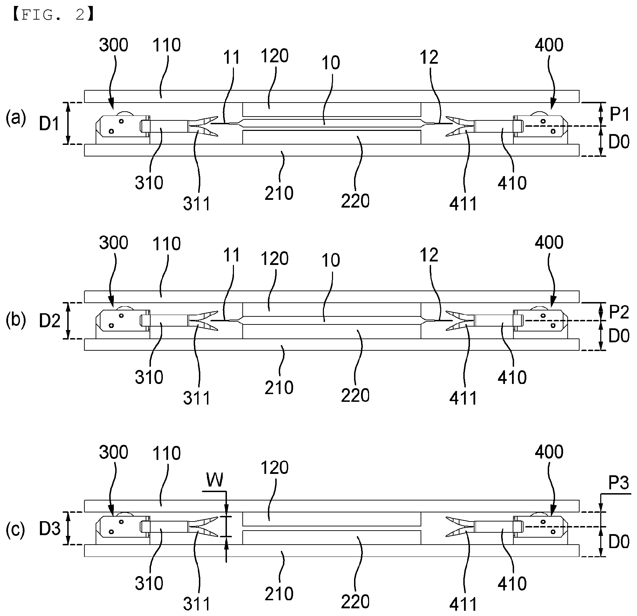

In this regard, FIG. 1 is a plan view of a conventional battery cell pressing jig, and FIG. 2 is a plan view showing the state before a pouch-shaped battery cell is pressed by the battery cell pressing jig of FIG. 1, the state in which the pouch-shaped battery cell is pressed by the battery cell pressing jig, and the state after the pouch-shaped battery cell is removed from the battery cell pressing jig.

Referring to FIGs. 1 and 2, the conventional battery cell pressing jig includes a first plate 110 located on a first side of the pouch-shaped battery cell 10 and a second plate 210 located on a second side of the pouch-shaped battery cell 10, wherein a first pad 120 is located between the first plate 110 and the pouch-shaped battery cell 10, and a second pad 220 is located between the second plate 210 and the pouch-shaped battery cell 10.

The pouch-shaped battery cell 10 includes a first electrode lead 11 and a second electrode lead 12, and a first voltage measurement unit 300 connected to the first electrode lead 11 and a second voltage measurement unit 400 connected to the second electrode lead 12 are fixed to the second plate 210.

The first voltage measurement unit 300 includes a first electrode lead guide 310 having a first insertion portion 311 formed at an end thereof so as to be coupled to the first electrode lead 11, and the second voltage measurement unit 400 includes a second electrode lead guide 410 having a second insertion portion 411 formed at an end thereof so as to be coupled to the second electrode lead 12.

In the conventional battery cell pressing jig, the first voltage measurement unit 300 and the second voltage measurement unit 400 are fixed to the second plate 210. As shown in (a), (b), (c) of FIG. 2, when the pouch-shaped battery cell is disposed on the battery cell pressing jig, there may be three positional relationships between the electrode lead and the voltage measurement unit.

In (a), (b), (c) of FIG. 2, D0 is the distance from the second plate 210 to the centerline of the second voltage measurement unit 400, and therefore D is uniform. However, when comparing D1, D2, and D3, which represent the distances between the first plate 110 and the second plate 210, D1 is the greatest, D2 is less than D1, and D3 is less than D2.

That is, the distance from the first plate 110 to the second voltage measurement unit 400 or the first voltage measurement unit 300 differs in (a), (b), and (c), respectively.

Thus, D0 may be configured to have the same value as P2 when the battery cell pressing jig firmly presses the pouch-shaped battery cell, as shown in (b).

However, the positions of the first electrode lead 11 and the second electrode lead 12 protruding from the pouch-shaped battery cell 10 may not be fixed, and the first electrode lead 11 and the second electrode lead 12 may be bent. In the case of (a), the first electrode lead 11 and the second electrode lead 12 may be bent upward, whereby the first electrode lead 11 and the second electrode lead 12 may deviate from at least one of the first insertion portion 311 and the second insertion portion 411, which may result in poor contact between the pouch-shaped battery cell 10 and the first voltage measurement unit 300 or the second voltage measurement unit 400.

Meanwhile, as shown in (c) of FIG. 2, when the pouch-shaped battery cell is removed from the battery cell pressing jig and the first plate 110 is located close to the first voltage measurement unit 300 and the second voltage measurement unit 400, the first insertion portion 311 and the second insertion portion 411 are in contact with the first plate 110. Therefore, the width w of each of the first insertion portion 311 and the second insertion portion 411 must be limited to 17.2 mm. With such a small width w, however, interference, such as the electrode leads contacting the outsides of the first insertion portion 311 and the second insertion portion 411, may occur, potentially causing poor contact.

Therefore, there is a need for a battery cell pressing jig configured such that the centers of voltage measurement units are located parallel to electrode leads of a pouch-shaped battery cell, regardless of the distance between a plate of the battery cell pressing jig and the pouch-shaped battery cell, and the electrode leads and the voltage measurement units can be stably connected to each other.

### [Disclosure]

### [Technical Problem]

The present invention has been made in view of the above problems, and it is an object of the present invention to provide a battery cell pressing jig configured such that an electrode lead guide of a voltage measurement unit of the battery cell pressing jig is always located parallel to an electrode lead of a pouch-shaped battery cell when the pouch-shaped battery cell is located on the battery cell pressing jig and a charging and discharging apparatus including the same.

### [Technical Solution]

A voltage measurement unit according to the present invention to accomplish the above object includes a distance adjustment portion constituted by two support shafts coupled so as to cross in an X-shape, bearings coupled to ends of the two support shafts, springs configured to restore by elastic force even if the crossing angle between the support shafts of the distance adjustment portion increases, and an electrode lead guide electrically connected to an electrode lead.

In the voltage measurement unit according to the present invention, in the X-shaped distance adjustment portion, the bearings may include two first bearings configured to be in contact with a first plate and two second bearings configured to be in contact with a second plate.

In the voltage measurement unit according to the present invention, the springs may be connected to ends on a first side and ends on a second side of the two support shafts, respectively.

In the voltage measurement unit according to the present invention, the electrode lead guide may include an insertion portion into which the electrode lead of the pouch-shaped battery cell is inserted, and a press contact portion, configured to be pressed by the electrode lead when the electrode lead is inserted into the first insertion portion, may be located in the insertion portion.

In the voltage measurement unit according to the present invention, an outside of the insertion portion may be formed in an inclined shape that gradually widens toward an end.

A battery cell pressing jig according to the present invention includes a first plate located on a first side of a pouch-shaped battery cell, a first pad attached to an outer surface of the first plate facing the pouch-shaped battery cell, a second plate located on a second side of the pouch-shaped battery cell, a second pad attached to an outer surface of the second plate facing the pouch-shaped battery cell, and a voltage measurement unit located between the first plate and the second plate, the voltage measurement unit being electrically connected to an electrode lead of the pouch-shaped battery cell in contact therewith.

In the battery cell pressing jig according to the present invention, the first pad may be added only to the part of the outer surface of the first plate that contacts the pouch-shaped battery cell, and the second pad may be added only to the part of the outer surface of the second plate that contacts the pouch-shaped battery cell.

In the battery cell pressing jig according to the present invention, the pouch-shaped battery cell may include a first electrode lead and a second electrode lead, and the voltage measurement unit may include a first voltage measurement unit electrically connected to the first electrode lead in contact therewith and a second voltage measurement unit electrically connected to the second electrode lead in contact therewith.

A charging and discharging apparatus including a battery cell pressing jig according to the present invention includes a base member configured to allow a plurality of battery cell pressing jigs to be mounted thereto so as to be stacked side by side, a pressing plate located on one side of the base member, the pressing plate being configured to press the plurality of battery cell pressing jigs, a support plate located on the other side of the base member, the support plate being configured to support the plurality of battery cell pressing jigs pressed by the pressing plate, and a gripping portion coupled to the pressing plate.

The charging and discharging apparatus according to the present invention may further include a mounting portion configured to allow voltage measurement units of the plurality of battery cell pressing jigs to be movably mounted thereto.

In the charging and discharging apparatus according to the present invention, when the pressing plate presses the plurality of battery cell pressing jigs, the first plate and the second plate may approach each other, causing the springs of the voltage measurement unit to stretch and the support shafts of the distance adjustment portion to spread apart.

In the charging and discharging apparatus according to the present invention, when force applied to the plurality of battery cell pressing jigs by the pressing plate is released, the first plate and the second plate may move apart from each other, causing the springs of the voltage measurement unit to contract and the support shafts of the distance adjustment portion to move closer together.

In the charging and discharging apparatus according to the present invention, the insertion portion of the voltage measurement unit into which the electrode lead is inserted may be located at the midpoint between the first plate and the second plate.

In addition, the present invention may provide various combinations of the above solving means.

### [Advantageous Effects]

In a battery cell pressing jig according to the present invention, a first voltage measurement unit and a second voltage measurement unit are not fixed to a first plate or a second plate but are located at the midpoint between the first plate and the second plate, whereby it is possible for the width center of a first insertion portion of the first voltage measurement unit and the width center of a second insertion portion of the second voltage measurement unit to be located on the same plane as electrode leads of a pouch-shaped battery cell.

In addition, contact interference between the first and second voltage measurement units and the first plate and between the first and second voltage measurement units and the second plate is reduced, whereby it is possible to increase the width of the first insertion portion and the width of the second insertion portion. When the first voltage measurement unit and the second voltage measurement unit are coupled to the electrode leads, therefore, it is possible to minimize poor coupling.

### [Description of Drawings]

FIG. 1 is a plan view of a conventional battery cell pressing jig.
FIG. 2 is a plan view showing the state before a pouch-shaped battery cell is pressed by the battery cell pressing jig of FIG. 1, the state in which the pouch-shaped battery cell is pressed by the battery cell pressing jig, and the state after the pouch-shaped battery cell is removed from the battery cell pressing jig.
FIG. 3 is a plan view of a voltage measurement unit of the present invention.
FIG. 4 is a perspective view of FIG. 3.
FIG. 5 is a plan view showing the state before a pouch-shaped battery cell is pressed by a battery cell pressing jig according to the present invention (a), the state in which the pouch-shaped battery cell is pressed by the battery cell pressing jig (b), and the state after the pouch-shaped battery cell is removed from the battery cell pressing jig (c).
FIG. 6 is a perspective view and a partial enlarged view of a charging and discharging apparatus according to the present invention.

### [Best Mode]

Now, preferred embodiments of the present invention will be described in detail with reference to the accompanying drawings such that the preferred embodiments of the present invention can be easily implemented by a person having ordinary skill in the art to which the present invention pertains. In describing the principle of operation of the preferred embodiments of the present invention in detail, however, a detailed description of known functions and configurations incorporated herein will be omitted when the same may obscure the subject matter of the present invention.

The same reference numbers will be used throughout the drawings to refer to parts that perform similar functions or operations. In the case in which one part is said to be connected to another part throughout the specification, not only may the one part be directly connected to the other part, but also, the one part may be indirectly connected to the other part via a further part. In addition, that a certain element is included does not mean that other elements are excluded, but means that such elements may be further included unless mentioned otherwise.

A description to embody elements through limitation or addition may be applied to all inventions, unless particularly restricted, and does not limit a specific invention.

In the description of the invention and the claims of the present application, singular forms are intended to include plural forms unless mentioned otherwise.

In the description of the invention and the claims of the present application, "or" includes "and" unless mentioned otherwise. Therefore, "including A or B" means three cases, namely, the case including A, the case including B, and the case including A and B.

Embodiments of the present invention will be described in more detail with reference to the drawings.

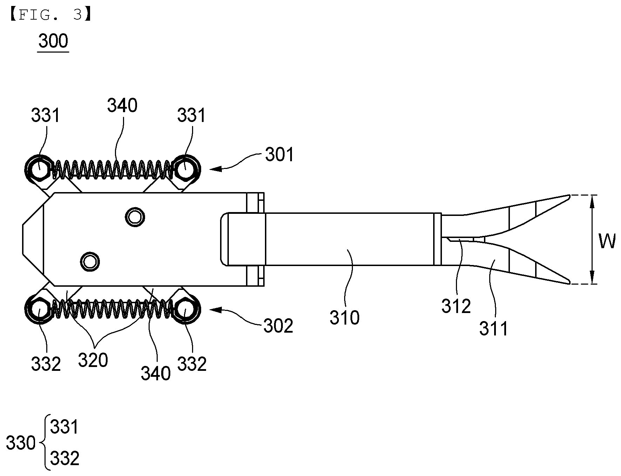

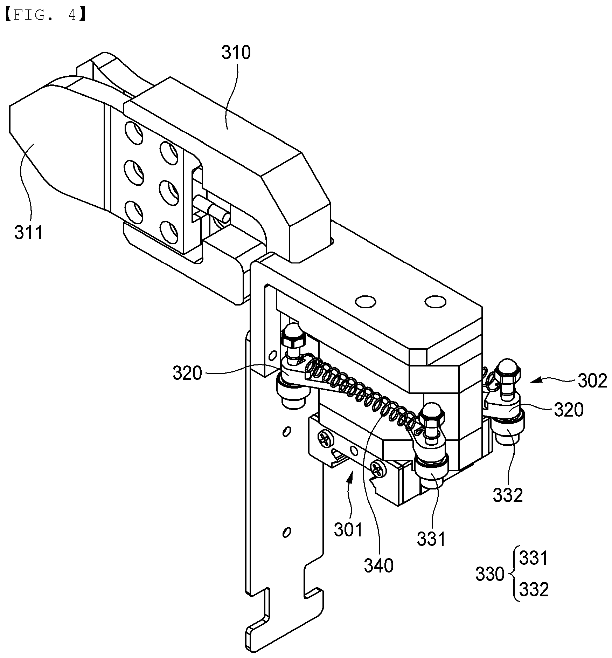

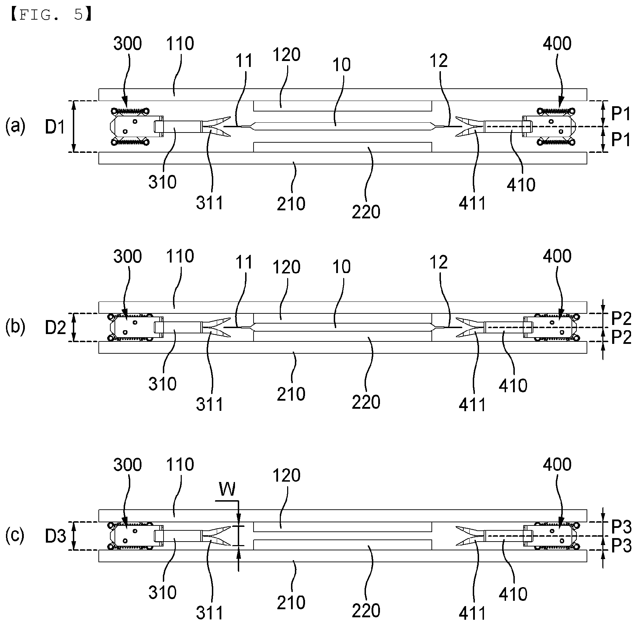

FIG. 3 is a plan view of a voltage measurement unit of the present invention, FIG. 4 is a perspective view of FIG. 3, and FIG. 5 is a plan view showing the state before a pouch-shaped battery cell is pressed by a battery cell pressing jig according to the present invention (a), the state in which the pouch-shaped battery cell is pressed by the battery cell pressing jig (b), and the state after the pouch-shaped battery cell is removed from the battery cell pressing jig (c).

Referring to FIGs. 3 to 5, the battery cell pressing jig according to the present invention includes a first plate 110 located on a first side of the pouch-shaped battery cell 10, a first pad 120 attached to an outer surface of the first plate 110 facing the pouch-shaped battery cell 10, a second plate 210 located on a second side of the pouch-shaped battery cell 10, a second pad 220 attached to an outer surface of the second plate 210 facing the pouch-shaped battery cell 10, and a voltage measurement unit located between the first plate 110 and the second plate 210, the voltage measurement unit being electrically connected to an electrode lead of the pouch-shaped battery cell 10 in contact therewith.

The pouch-shaped battery cell 10 includes a first electrode lead 11 and a second electrode lead 12 protruding in opposite directions, and the voltage measurement unit includes a first voltage measurement unit 300 electrically connected to the first electrode lead 11 in contact therewith and a second voltage measurement unit 400 electrically connected to the second electrode lead 12 in contact therewith. In this case, the first voltage measurement unit 300 and the second voltage measurement unit 400 are constituted as separate members that are not fixed to the first plate 110 and the second plate 210.

Therefore, the first voltage measurement unit 300 and the second voltage measurement unit 400 may be in contact with the first plate 110 and the second plate 210, respectively, or may be spaced apart from the first plate 110 and the second plate 210, respectively.

In (a) of FIG. 5, the first voltage measurement unit 300 and the second voltage measurement unit 400 are spaced apart from the first plate 110 and the second plate 210, respectively. In (b) of FIG. 5, the first voltage measurement unit 300 and the second voltage measurement unit 400 are in contact with the first plate 110 and the second plate 210, respectively.

In FIG. 5, D1, D2, and D3 are the distances between the first plate 110 and the second plate 210, wherein D1 is greater than D2, and D3 is less than D2.

Furthermore, in (a), (b), and (c) of FIG. 5, the distances between the voltage measurement units and the first plate 110 may be equal to the distances between the voltage measurement units and the second plate 210. That is, in (a), (b), and (c) of FIG. 5, the distances P1, P2, and P3 between the second voltage measurement unit 400 and the first plate 110 are equal to the distances P1, P2, and P3 between the second voltage measurement unit 400 and the second plate 210.

At this time, the first voltage measurement unit 300 is considered to be located at the same position as the second voltage measurement unit 400 on a horizontal line of the figure.

Conventionally, the first voltage measurement unit 300 and the second voltage measurement unit 400 are attached to the first plate 110, whereby D0 of FIG. 1 has a certain limit value. Therefore, when a pouch-shaped battery cell is not disposed in the battery cell pressing jig, it is difficult to increase the width of the insertion portions of the electrode lead guides of the first voltage measurement unit 300 and the second voltage measurement unit 400.

In the present invention, the first voltage measurement unit 300 and the second voltage measurement unit 400 are located so as not to be biased toward any one of the first plate 110 and the second plate 210, whereby the width w of the insertion portion may be greater than the width of the insertion portion in the conventional battery cell pressing jig. For example, when using the same plates and pouch-shaped battery cell as in the conventional battery cell pressing jig shown in FIGs. 1 and 2, the width w of the insertion portion in the present invention may be 23.25 mm. That is, compared to the width of the conventional insertion portion, which is 17.2 mm, an increase of approximately 35% may be achieved.

Therefore, even if the first electrode lead 11 and second electrode lead 12 of the pouch-shaped battery cell 10 are curved or bent, the risk of the first electrode lead 11 and the second electrode lead 12 contacting the first voltage measurement unit 300 and/or the second voltage measurement unit 400 may be reduced.

The first pad 120 and the second pad 220 may ensure that the pressing force applied to the pouch-shaped battery cell 10 by the first plate 110 and the second plate 210 is uniform, and may prevent damage to the pouch-shaped battery cell 10.

Therefore, the first pad 120 is added only to the part of the outer surface of the first plate 110 that contacts the pouch-shaped battery cell 10, and the second pad 220 is added only to the part of the outer surface of the second plate 210 that contacts the pouch-shaped battery cell 10. That is, the first pad 120 is located only at a central portion of the first plate 110, and the second pad 220 is located only at a central portion of the second plate 210. In addition, the first voltage measurement unit 300 and the second voltage measurement unit 400 face the first plate 110 without the first pad 120 and face the second plate 210 without the second pad 120.

FIGs. 3 and 4 show the first voltage measurement unit 300, a description of which applies equally to the second voltage measurement unit 400.

The first voltage measurement unit 300 includes a distance adjustment portion constituted by two support shafts 320 coupled so as to cross in an X-shape, bearings 330 coupled to ends of the two support shafts 320, springs 340 configured to be restored by elastic force after the angle between the support shafts of the distance adjustment portion increases, and a first electrode lead guide 310 electrically connected to the first electrode lead 11 and the second electrode lead 12. The springs 340 are connected to ends on a first side 301 and ends on a second side 302 of the two support shafts 320, respectively.

The spring 340 may prevent the crossing angle between the two support shafts 320 from becoming too large in the state in which the two support shafts 320 are coupled so as to cross in an X-shape, and conversely, may decrease the crossing angle between the support shafts 320 using the elastic force of the spring 340. For example, when the first plate 110 and the second plate 210 press the pouch-shaped battery cell 10, the X-shaped crossing angle between the two support shafts 320 becomes the maximum, and when the state of the first plate 110 and the second plate 210 pressing the pouch-shaped battery cell 10 is released, the restoring force due to the elastic force of the spring may reduce the crossing angle between the two support shafts 320.

The first electrode lead guide 310 includes a first insertion portion 311 into which the electrode lead of the pouch-shaped battery cell is inserted, and a first press contact portion 312, configured to be pressed by the electrode lead when the electrode lead is inserted into the first insertion portion 311, is located in the first insertion portion 311. For example, the first press contact portion 312 may be constituted by a pogo pin, and the electrode lead may be coupled to the first press contact portion 312 while pressing the first press contact portion 312.

The outside of the first insertion portion 311 is formed in an inclined shape that gradually widens toward the end. Therefore, even if the first electrode lead 11 and the second electrode lead 12 are curved or bent, the first electrode lead 11 and the second electrode lead 12 may be inserted into the first insertion portion 311 and coupled to the first press contact portion 312 while pressing the first press contact portion 312, as long as the first electrode lead 11 and the second electrode lead 12 do not deviate from the width w of the end of the first insertion portion 311. As a result, the electrode lead is electrically connected to the first voltage measurement unit, whereby it is possible to measure the voltage of the pouch-shaped battery cell while charging and discharging the pouch-shaped battery cell.

In the present invention, the width w of the first insertion portion 311 is large, which is optimized for insertion and stable coupling of the first electrode lead 11 and the second electrode lead 12 into and to the first insertion portion 311.

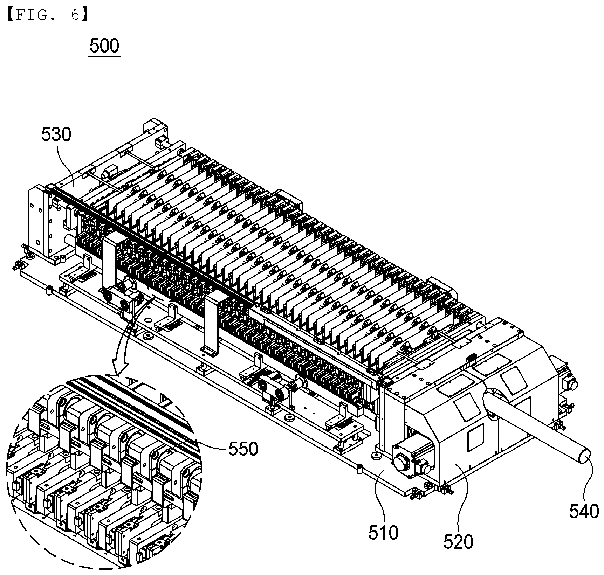

FIG. 6 is a perspective view and a partial enlarged view of a charging and discharging apparatus according to the present invention.

Referring to FIG. 6, the charging and discharging apparatus 500 according to the present invention includes a base member 510 configured to allow a plurality of battery cell pressing jigs to be mounted thereto so as to be stacked side by side, a pressing plate 520 located on one side of the base member 510, the pressing plate being configured to press the plurality of battery cell pressing jigs, a support plate 530 located on the other side of the base member 510, the support plate being configured to support the plurality of battery cell pressing jigs pressed by the pressing plate 520, and a gripping portion 540 coupled to the pressing plate 520.

The charging and discharging apparatus further includes a mounting portion 550 configured to allow first voltage measurement units and second voltage measurement units of the plurality of battery cell pressing jigs to be movably mounted thereto.

For example, the mounting portion 550 may be configured to pass through the plurality of battery cell pressing jigs, and the plurality of battery cell pressing jigs may move horizontally parallel to an upper surface of the base member 510 with the mounting portion 550 as a fixed axis.

In the charging and discharging apparatus 500, a pouch-shaped battery cell is disposed between the first plate and the second plate of each of the plurality of battery cell pressing jigs in the state in which the first plate and the second plate are disposed spaced apart from each other.

When the pressing plate 520 is pressed toward the support plate 530 to measure the voltages of the pouch-shaped battery cells in the state in which the pouch-shaped battery cells are pressed, the first plates, the second plates, and the voltage measurement units move toward the support plate 530, whereby each pouch-shaped battery cell is in tight contact with the first plate and the second plate.

At this time, the first voltage measurement unit and the second voltage measurement unit, located between the first plate and the second plate, also move toward the support plate 530, whereby the first voltage measurement unit and the second voltage measurement unit are in tight contact with the first plate and the second plate, and the distance between the center of each of the first voltage measurement unit and the second voltage measurement unit and the first plate and the distance between the center of each of the first voltage measurement unit and the second voltage measurement unit and the second plate are equal.

That is, in all states including the state before the pouch-shaped battery cells are pressed by the charging and discharging apparatus, the state in which the pouch-shaped battery cells are pressed by the charging and discharging apparatus, and the state after the pouch-shaped battery cells are removed from the charging and discharging apparatus, the insertion portion of each of the first voltage measurement unit 300 and the second voltage measurement unit 400 into which the first electrode lead 11 and the second electrode lead 12 are inserted is located at the midpoint between the first plate 110 and the second plate 210.

Referring to FIG. 6 together with FIGs. 3 and 4, the bearings 330 of the X-shaped distance adjustment portion include two first bearings 331 configured to be in contact with the first plate 110 and two second bearings 332 configured to be in contact with the second plate 210. As the first plate 110 and the second plate 210 approach each other, the first bearings 331 come into contact with the first plate 110, and the second bearings 332 come into contact with the second plate 210. As the first plate 110 and the second plate 210 come closer together, the pouch-shaped battery cell 10 is pressed, whereby the first bearings 331 move along the surface of the first plate 110 and the second bearings 332 move along the surface of the second plate 210, increasing the X-shaped crossing angle between the support shafts 320.

In the present invention, the bearings are provided at the ends of the support shafts 320, whereby the frictional force between the bearings and the first plate 110 and the second plate 210 may be minimized. Therefore, the pressing force applied to the first plate 110 and the second plate 210 by the pressing plate 520 may be transmitted to the pouch-shaped battery cell 10 such that the pouch-shaped battery cell can be pressed.

In addition, after the first plate 110 and the second plate 210 press the pouch-shaped battery cell 10, the first voltage measurement unit 300 moves toward the first electrode lead 11, and the second voltage measurement unit 400 moves toward the second electrode lead 12. At this time, the first voltage measurement unit 300 and the second voltage measurement unit 400 may move easily due to the rotation of the bearings.

The process of applying force to the pouch-shaped battery cell and the process of releasing the force in the charging and discharging apparatus according to the present invention will be described.

First, when the pressing plate 520 presses the plurality of battery cell pressing jigs, the first plate 110 and the second plate 210 approach each other, causing the springs 340 of the first voltage measurement unit 300 and the second voltage measurement unit 400 to stretch and the support shafts 320 of the distance adjustment portion to spread apart.

Meanwhile, when the force applied to the plurality of battery cell pressing jigs by the pressing plate 520 is released, the first plate 110 and the second plate 210 move apart from each other, causing the springs 340 of the first voltage measurement unit 300 and the second voltage measurement unit 400 to contract and the support shafts 320 of the distance adjustment portion to move closer together.

In the charging and discharging apparatus according to the present invention, as described above, the springs 340 are fixed to the support shafts 320, and therefore when the force applied to the pouch-shaped battery cell 10 by the first plate 110 and the second plate 210 is released, the elastic force of the springs 340 causes the X-shaped angle between the first support shafts 320 to decrease, allowing the support shafts to return to the previous state thereof.

Those skilled in the art to which the present invention pertains will appreciate that various applications and modifications are possible within the scope of the present invention based on the above description.

### (Description of Reference Numerals)

10: Pouch-shaped battery cell
11: First electrode lead
12: Second electrode lead
110: First plate
120: First pad
210: Second plate
220: Second pad
300: First voltage measurement unit
301: First side
302: Second side
310: First electrode lead guide
311: First insertion portion
312: First pressure contact portion
320: Support shaft
330: Bearing
331: First bearing
332: Second bearing
340: Spring
400: Second voltage measurement unit
410: Second electrode lead guide
411: Second insertion portion
500: Charging and discharging apparatus
510: Base member
520: Pressing plate
530: Support plate
540: Gripping portion
550: Mounting portion

## Claims

1. A voltage measurement unit comprising:
a distance adjustment portion constituted by two support shafts coupled so as to cross in an X-shape;
bearings coupled to ends of the two support shafts;
springs configured to restore by elastic force even if a crossing angle between the support shafts of the distance adjustment portion increases; and
an electrode lead guide electrically connected to an electrode lead.

2. The voltage measurement unit according to claim 1, wherein, in the X-shaped distance adjustment portion, the bearings comprise two first bearings configured to be in contact with a first plate and two second bearings configured to be in contact with a second plate.

3. The voltage measurement unit according to claim 1, wherein the springs are connected to ends on a first side and ends on a second side of the two support shafts, respectively.

4. The voltage measurement unit according to claim 1, wherein
the electrode lead guide comprises an insertion portion into which the electrode lead of the pouch-shaped battery cell is inserted, and
a press contact portion, configured to be pressed by the electrode lead when the electrode lead is inserted into the first insertion portion, is located in the insertion portion.

5. The voltage measurement unit according to claim 4, wherein an outside of the insertion portion is formed in an inclined shape that gradually widens toward an end.

6. A battery cell pressing jig comprising:
a first plate located on a first side of a pouch-shaped battery cell;
a first pad attached to an outer surface of the first plate facing the pouch-shaped battery cell;
a second plate located on a second side of the pouch-shaped battery cell;
a second pad attached to an outer surface of the second plate facing the pouch-shaped battery cell; and
a voltage measurement unit located between the first plate and the second plate, the voltage measurement unit being electrically connected to an electrode lead of the pouch-shaped battery cell in contact therewith.

7. The battery cell pressing jig according to claim 6, wherein
the first pad is added only to a part of the outer surface of the first plate that contacts the pouch-shaped battery cell, and
the second pad is added only to a part of the outer surface of the second plate that contacts the pouch-shaped battery cell.

8. The battery cell pressing jig according to claim 6, wherein
the pouch-shaped battery cell comprises a first electrode lead and a second electrode lead, and
the voltage measurement unit comprises a first voltage measurement unit electrically connected to the first electrode lead in contact therewith and a second voltage measurement unit electrically connected to the second electrode lead in contact therewith.

9. A charging and discharging apparatus comprising the battery cell pressing jig according to any one of claims 6 to 8, the charging and discharging apparatus comprising:
a base member configured to allow a plurality of battery cell pressing jigs to be mounted thereto so as to be stacked side by side;
a pressing plate located on one side of the base member, the pressing plate being configured to press the plurality of battery cell pressing jigs;
a support plate located on the other side of the base member, the support plate being configured to support the plurality of battery cell pressing jigs pressed by the pressing plate; and
a gripping portion coupled to the pressing plate.

10. The charging and discharging apparatus according to claim 9, further comprising a mounting portion configured to allow voltage measurement units of the plurality of battery cell pressing jigs to be movably mounted thereto.

11. The charging and discharging apparatus according to claim 9, wherein, when the pressing plate presses the plurality of battery cell pressing jigs, the first plate and the second plate approach each other, causing the springs of the voltage measurement unit to stretch and the support shafts of the distance adjustment portion to spread apart.

12. The charging and discharging apparatus according to claim 9, wherein, when force applied to the plurality of battery cell pressing jigs by the pressing plate is released, the first plate and the second plate move apart from each other, causing the springs of the voltage measurement unit to contract and the support shafts of the distance adjustment portion to move closer together.

13. The charging and discharging apparatus according to claim 9, wherein the insertion portion of the voltage measurement unit into which the electrode lead is inserted is located at a midpoint between the first plate and the second plate.
